# FASCICULE DE BREVET EUROPEEN

(11) **EP 1 258 029 B1**
(45) Date de publication et mention de la délivrance du brevet: **21.03.2007**
(21) Numéro de dépôt: 01907726.2
(22) Date de dépôt: 07.02.2001
(51) Int. Cl.: H01L 21/04

(54) **PROCEDE DE TRAITEMENT D'UNE SURFACE DE DIAMANT ET SURFACE DE DIAMANT CORRESPONDANTE**
BEHANDLUNGSMETHODE FÜR EINE DIAMANTOBERFLÄCHE UND ENTSPRECHENDE OBERFLÄCHE
METHOD FOR TREATING A DIAMOND SURFACE AND CORRESPONDING DIAMOND SURFACE

(30) Priorité: 09.02.2000 FR 0001604
(43) Date de publication de la demande: 20.11.2002
(73) Titulaire: UNIVERSITE PIERRE ET MARIE CURIE, 75252 Paris Cédex 05 (FR)
(72) Inventeur: BRIAND, Jean-Pierre, F-92160 Antony (FR); BECHU, Nicolas, F-75006 Paris (FR); GICQUEL, Alix, F-92300 Levallois Perret (FR); ACHARD, Jocelyn, F-95880 Enghien les Bains (FR)
(74) Mandataire: Catherine, Alain
(86) Numéro de dépôt international: PCT/FR2001/000360
(87) Numéro de publication internationale: WO 2001/059817

(56) Documents cités:
- FR-A- 2 757 881
- FR-A- 2 764 110
- WATANABE H ET AL: "EFFECT OF ION IMPLANTATION ON ION-PLATED DIAMOND-LIKE CARBON FILMS" DIAMOND AND RELATED MATERIALS,NL,ELSEVIER SCIENCE PUBLISHERS, AMSTERDAM, vol. 3, no. 8, 1 juin 1994 (1994-06-01), pages 1117-1119, XP000483456 ISSN: 0925-9635

## Description

La présente invention est relative à un procédé de traitement d'une surface dans lequel:
- on produit des ions ayant chacun au moins trois charges positives, et
- on envoie un faisceau de ces ions vers la surface.

L'invention se rapporte également à une surface de diamant correspondante et à des applications d'un tel procédé ou d'une telle surface.

Un procédé du type énoncé plus haut a été décrit dans les demandes internationales WO-98/29901 et WO-98/54747.

Plus précisément, le document WO-98/29901 est relatif à une modification de structure sans contact des ions avec une surface d'un semi-conducteur, de manière à créer dans cette surface des zones isolantes.

Le document WO-98/54747 décrit quant à lui une technique de gravure par ions. Dans un mode de réalisation particulier divulgué dans ce document (voir la revendication 8), on envoie le faisceau vers un semi-conducteur ou un isolant et on modifie localement la nature électrique ou chimique ou la topographie de la surface par ce faisceau, sans que le faisceau n'entre en contact avec la surface.

L'article de Watanabe et al. paru sous le titre "Effect of ion implantation on ion-plated diamond-like carbon films" dans Diamond and Related Materials 3(1994) 1117-1119, a pour objet le contrôle, par implantation d'ions chargés, de la structure d'un film de carbone équivalent au diamant (D.L.C) constituant un revêtement dur pour aciers à outils.

La présente invention selon la revendication 1 vise une technique permettant de former des zones conductrices sur une surface isolante, pouvant ne nécessiter, de manière surprenante, que le seul envoi d'un faisceau d'ions. L' invention vise une telle technique rendant possible la formation de telles zones de petites dimensions et contrôlables.

L'invention est ainsi relative à un procédé de traitement d'une, surface isolante permettant de rendre conductrice au moins une zone de cette surface, mettant en oeuvre contre toute attente l'envoi d'un faisceau d'ions vers la surface.

L'invention concerne également une surface isolante délimitant des îlots conducteurs ayant un diamètre inférieur à 10 nm, pouvant être obtenue par le procédé de traitement de l'invention.

L'invention vise également des applications de la présente technique à la micro-électronique, pour la réalisation de réservoirs à un électron, et à la fabrication de cathodes froides, notamment pour écrans plats.

A cet effet, l'invention a pour objet un procédé de traitement d'une surface dans lequel:
- on produit des ions ayant chacun au moins trois charges positives, et
- on envoie un faisceau desdits ions positifs multichargés vers la surface de diamant, de façon à provoquer sur au moins une zone de cette surface, une modification structurelle locale permettant de rendre conductrice ladite zone,
- chaque ion ayant une charge, une énergie cinétique et une incidence telles que la modification structurelle produite s'étende sur une superficie supérieure à quatre fois et préférentiellement à dix fois la surface d'un atome dudit diamant et inférieure à 22500 nm².

Par « diamant », on entend non seulement un diamant naturel ou artificiel (préparé par exemple par une méthode CVD - Chemical Vapor Deposition - ou HPHT - hautes pressions hautes températures), polycristallin ou monocristallin, mais aussi un « carbone sp 3 amorphe » (diamondlike carbon), qui a une liaison sp 3 comme le diamant mais une autre structure cristallographique. La surface de diamant est avantageusement préparée en couche mince sur un substrat préférentiellement constitué de silicium.

Il est particulièrement surprenant que l'envoi d'un faisceau d'ions sur une telle surface isolante, constituée de diamant (c'est-à-dire de carbone pur cristallisé dans une structure diamant), puisse aboutir localement à la formation stable de zones conductrices. Cet effet repose sur un phénomène physique inexploré jusqu'alors, selon lequel la structure du diamant peut être modifiée sur une faible surface en une variété allotropique conductrice, par un ou plusieurs ions singuliers. En effet, le carbone présente plusieurs formes allotropiques cristallines comprenant notamment le diamant (forme isolante) et le graphite (forme conductrice), et un ion ayant au moins trois charges positives est capable de provoquer dans une surface de diamant un défaut grand par rapport à des dimensions atomiques mais macroscopiquement de faible taille. Un tel ion provoque au sein de la surface de diamant un exode massif d'électrons permettant d'obtenir ce résultat.

Par contraste, par exemple, la technique décrite dans le document WO-98/54747 repose sur l'expulsion d'atomes présents dans les molécules de la surface visée (voir en particulier page 8, lignes 7-19) et est donc très éloignée dans son but et dans son application du procédé de la présente invention.

Les opérations avec le faisceau d'ions sont préférentiellement effectuées sous vide. Ce vide peut correspondre à une pression relativement élevée, par exemple de l'ordre de 10⁻⁹ Pa. Il peut aussi être un ultravide.

Les ions ayant chacun au moins trois charges positives sont appelés des ions positifs multichargés. Les ions monochargés, par exemple, ne peuvent aucunement produire l'effet indiqué, consistant en la création locale de zones conductrices stables à la surface du diamant. Des ions monochargés très énergétiques pourraient a priori casser localement des liaisons cristallographiques ou chimiques lors de leur traversée de tout matériau. Cependant, ils ne créeraient que des défauts ponctuels en surface de l'ordre de dimensions atomiques. De tels défauts en profondeur ponctuels en surface, n'autorisent pas l'utilisation des zones conductrices créées. Notamment, les défauts ainsi produits ont tendance à être naturellement réparés par effets thermiques de telle sorte qu'un traitement chimique ultérieur serait nécessaire pour obtenir une zone conductrice stable.

Les zones conductrices formées ont des propriétés conductrices similaires à celles du graphite, ce qui s'explique par la modification structurelle du diamant de manière à le faire passer à une autre variété allotropique non diamant, se manifestant en particulier par une perte du caractère cristallin du diamant.

Le procédé ci-dessus est applicable à la formation de zones conductrices localisées de très petites dimensions, telles que des îlots conducteurs ayant un diamètre inférieur à 150 nm et préférentiellement inférieur à 10 nm, à la formation de traits conducteurs ou de portions de surfaces conductrices ou à la modification structurelle de toute la surface de diamant.

La zone conductrice engendrée par l'impact d'un des ions du faisceau a une surface et une profondeur déterminées sur une surface de diamant donnée par la charge, l'énergie cinétique et éventuellement l'incidence de l'ion.

Par contraste, les ions monochargés ne peuvent produire individuellement que des défauts ayant une superficie inférieure à 10 surfaces atomiques, et l'envoi massif d'un faisceau d'ions ne peut aboutir qu'à des surfaces conductrices bien plus étendues que 22.500 nm².

Par la suite, on entend par « modification structurelle locale » une modification sur une superficie dans la plage indiquée ci-dessus.

Dans un premier mode de mise en oeuvre préféré avec modification structurelle locale, on envoie le faisceau de façon à former au moins un îlot conducteur ayant un diamètre inférieur à 150 nm.

Avantageusement, les îlots conducteurs ont un diamètre inférieur à 10 nm et préférentiellement compris entre 2 et 6 nm. Le procédé de traitement de l'invention rend possible une telle précision de modification structurelle locale, chacun des ions pouvant former un îlot.

On utilise alors de préférence les îlots conducteurs comme réservoirs à un électron (dots). Ces derniers sont particulièrement utiles pour leurs applications en micro-électronique.

Dans une autre forme de ce premier mode de mise en oeuvre, on utilise les îlots conducteurs comme réservoirs de réalimentation de cathodes froides. La taille des îlots conducteurs est alors avantageusement supérieure à 10 nm, et encore préférentiellement à 100 nm.

Selon un second mode préféré de mise en oeuvre, on envoie le faisceau de façon à former des traits conducteurs délimitant des motifs isolants.

Selon un troisième mode préféré de mise en oeuvre, on envoie le faisceau de façon à rendre conductrice au moins une fraction de la surface de diamant.

Pour ce faire, on a avantageusement recours à une modification structurelle locale de ces fractions de surface par balayage avec un faisceau. Cela autorise une précision correspondant à la dimension du faisceau et à son guidage, c'est-à-dire classiquement inférieure au micron.

Dans une forme particulière de ce troisième mode de mise en oeuvre, on rend conductrice toute la surface de diamant.

Selon un mode préféré de modification structurelle locale, celle-ci est effectuée aléatoirement. Ainsi, en particulier, le premier mode de mise en oeuvre consiste alors à former des îlots conducteurs répartis de manière aléatoire sur la surface de diamant, le nombre d'îlots conducteurs par unité de surface étant défini par le nombre d'ions atteignant cette surface.

Dans un autre mode de modification structurelle locale, celle-ci est effectuée selon un schéma prédéterminé.

En particulier, avantageusement, on traite sélectivement les zones de la surface en envoyant le faisceau vers des moyens de guidage, en dirigeant le faisceau vers la surface avec les moyens de guidage, et en procédant de manière répétée aux opérations suivantes:
- on fait une détection spatio-temporelle d'interactions d'ions du faisceau avec la surface,
- on interrompt le faisceau,
- on effectue un déplacement relatif de la surface par rapport à la position du faisceau, et
- on rétablit le faisceau.

Le déplacement relatif de la surface par rapport à la position du faisceau peut impliquer un déplacement de la surface ou un déplacement du faisceau, par variation de leur position ou de leur orientation. On effectue ainsi la modification structurelle locale de manière successive, zone après zone. Dans une variante de mise en oeuvre, on dirige simultanément plusieurs faisceaux vers la surface.

La détection spatio-temporelle consiste à identifier à la fois les positions et les instants des interactions.

En procédant de cette manière, on maîtrise les durées d'exposition de la surface de diamant et les déplacements relatifs de cette surface par rapport au faisceau d'ions. Cette maîtrise procure une très grande fiabilité. En effet, la modification structurelle locale par ions met en jeu une arrivée aléatoire des ions sur la cible, à la fois du point de vue spatial et temporel. Le procédé de modification structurelle locale contrôlée comme indiqué ci-dessus permet d'adapter le traitement à ces phénomènes aléatoires.

On trouvera une description détaillée de plusieurs modes de mise en oeuvre d'un tel procédé dans la demande internationale WO-98/54747. Tous ces modes de mise en oeuvre sont applicables à la présente invention, le contrôle de modification structurelle locale de cet état de la technique étant combiné avec le choix d'une surface de diamant et l'utilisation d'ions ayant chacun au moins trois charges positives.

En particulier, les caractéristiques suivantes sont avantageusement mises en oeuvre, séparément ou selon toutes leurs combinaisons techniquement possibles:
- on localise spatialement le faisceau d'ions entre la source d'ions et la surface à traiter, préférentiellement au moyen d'un ou plusieurs collimateurs de faisceau,
- on contrôle la position du faisceau et on le refroidit,
- on effectue une sélection monocinétique des ions entre la source d'ions et la surface à traiter,
- on interrompt le faisceau par des moyens d'application d'un champ électrique approximativement parallèle à la surface à traiter, avantageusement en combinaison avec l'utilisation d'un collimateur,
- les moyens de guidage comprennent des moyens d'application d'un champ magnétique, déviant le faisceau d'ions d'un certain angle, ce champ magnétique étant préférentiellement uniforme et l'angle de déviation valant préférentiellement 90°,
- les moyens de guidage comprennent des moyens d'application d'un champ électrique produisant une déviation électrique,
- les moyens de guidage mettent en oeuvre à la fois un champ magnétique et un champ électrique combinés, par exemple dans un filtre de Wien,
- on effectue le déplacement relatif de la surface par rapport à la position du faisceau au moyen d'au moins un élément choisi parmi un quartz piézo-électrique et une céramique, déplaçant la surface de diamant par rapport au faisceau d'ions incidents sur cette surface,
- on effectue un contrôle local topographique et/ou de conductivité électrique de la surface traitée, préférentiellement au moyen d'un microscope à effet tunnel et/ou à force atomique,
- on produit une interaction des ions avec la surface à traiter sans contact entre le faisceau et la surface; la détection spatio-temporelle comprend alors une technique de détection choisie parmi:
   - la mesure de photons émis lors de passages d'électrons extraits d'une couche électronique à une autre d'atomes creux du faisceau d'ions (préférentiellement mesure de rayons X émis),
   - la détection d'électrons émis par effet Auger par les atomes creux,
   - la détection des ions ou atomes creux eux-mêmes (préférentiellement position, vitesse et charge des atomes creux rétrodiffusés),
   - la détection de fragments ionisés de molécules de la surface de traitement expulsés sous l'effet des interactions (atomes dessoudés),
   - la détection d'une gerbe d'électrons émis sous l'effet des interactions,
   - la mesure de photons émis par des atomes de la surface de diamant, et
   - la combinaison de plusieurs de ces techniques.

Le procédé de traitement peut impliquer une interaction à distance, par effet potentiel, et/ou une interaction avec contact du faisceau d'ions et de la surface de diamant, pouvant impliquer une pénétration des ions sous la surface (effet cinétique).

Ainsi, dans une première forme préférée d'interaction, on envoie le faisceau d'ions de façon qu'il entre en contact avec la surface et la pénètre. On produit alors avantageusement les ions ayant une énergie cinétique initiale comprise entre 5 eV/q et 500 keV/q.

Dans une seconde forme d'interaction, on applique au faisceau une tension de décélération à proximité de la surface, de manière à donner aux ions du faisceau une vitesse moyenne commandée, les ions extrayant des électrons des atomes de diamant sans entrer en contact avec la surface et modifiant ainsi les liaisons entre ces atomes.

On ralentit alors avantageusement les ions de façon à ce qu'ils aient à proximité de la surface une énergie cinétique comprise entre 5.10⁻² eV/q et 5 eV/q.

Cette technique d'interaction sans contact est décrite en détail dans la demande internationale WO-98/54747, dans le cas d'un contrôle de gravure, et dans la demande internationale WO-98/29901, pour la formation de zones isolantes sur une surface semi-conductrice. L'ensemble des techniques exposées et développées dans ces deux antériorités doit être transposé à la présente demande, avec les ajustements suivants: en ce qui concerne la demande WO-98/54747, le procédé doit être spécifié pour un faisceau d'ions multichargés et une surface de diamant. Par ailleurs, le présent procédé n'est pas limité à la technique de contrôle de modification structurelle locale décrite dans cette antériorité et est en particulier valable pour un gravure aléatoire. En ce qui concerne le document WO-98/29901, le procédé de traitement est appliqué à une surface de diamant et on produit ainsi des zones conductrices sur une surface isolante, et non des zones isolantes sur une surface semi-conductrice.

Selon une troisième forme d'interaction, les ions touchent la surface mais sans choc violent, de telle sorte qu'ils ne peuvent pas pénétrer la surface et n'interagissent que dans la partie la plus superficielle de cette surface.

Dans le troisième mode d'interaction, on ralentit avantageusement les ions jusqu'à atteindre une énergie respectivement inférieure à 5 eV/q et à 25 eV/q.

Dans une première forme de réalisation avantageuse de la surface de diamant, celle-ci est une surface de diamant monocristallin, artificielle ou naturelle.

Dans une deuxième forme avantageuse, elle est une surface de diamant polycristallin, préférentiellement obtenue par une technique de dépôt de vapeur chimique (Chemical Vapor Deposition ou CVD) ou une technique hautes pressions hautes températures (HPHT). La surface de diamant est alors avantageusement une couche déposée sur un substrat par exemple de silicium.

L'utilisation d'une surface de diamant polycristallin ayant des monocristaux de tailles variées, préférentiellement CVD ou HPHT, a pour effet avantageux d'accroître le nombre d'électrons disponibles. En effet, une telle réalisation permet de modifier la fraction de la surface cristalline par rapport à des joints de grain qui sont conducteurs, ces derniers pouvant ainsi fournir davantage d'électrons à leurs voisins isolants.

La technique d'irradiation d'une telle surface permet aussi de contrôler le rapport surface conductrice sur surface isolante a posteriori et d'une manière industriellement aisée.

Ces mises en oeuvre avec monocristaux de tailles variées sont particulièrement intéressantes pour la fabrication de cathodes froides, car elles assurent une réalimentation en électrons.

Dans une troisième forme avantageuse, cette surface est une surface de carbone sp 3 amorphe.

Avantageusement, la surface de diamant est passivée par une monocouche atomique, préférentiellement d'hydrogène ou d'oxygène. Cette monocouche peut être conductrice exemple: hydrogène ou isolante (exemple: oxygène). Dans une autre forme de réalisation, la surface de diamant est naturelle.

L'invention a également pour objet une surface de diamant délimitant des îlots conducteurs ayant un diamètre supérieur à 2 et préférentiellement à 3 distances atomiques et inférieur à 10 nm, et préférentiellement compris entre 2 et 6 nm.

Les îlots ont avantageusement des propriétés conductrices similaires à celle du graphite.

Une telle surface peut notamment être obtenue par le procédé de traitement selon l'invention.

L'invention concerne aussi l'application d'une telle surface à la microélectronique, dans laquelle on utilise les îlots conducteurs comme réservoirs à un électron.

L'invention a également pour objet l'application du procédé de traitement à la fabrication de cathodes froides, notamment pour écrans plats.

L'invention sera illustrée et mieux comprise à l'aide de modes de mise en oeuvre et de réalisation de l'invention donnés ci-dessous en référence aux dessins annexés, sur lesquels:
La Figure 1 montre une plaquette de silicium recouverte d'une couche de diamant;
La Figure 2A montre la plaquette de la Figure 1 après l'application du procédé de l'invention selon un premier mode de mise en oeuvre;
La Figure 2B montre la plaquette de la Figure 1 après l'application du procédé de l'invention selon un deuxième mode de mise en oeuvre;
La Figure 2C montre la plaquette de la Figure 1 après l'application du procédé de l'invention sur un troisième mode de mise en oeuvre;
La Figure 3 est un schéma synoptique des différentes étapes d'un procédé selon l'invention avec contrôle de modification structurelle locale, permettant d'obtenir une plaquette telle que celle de la Figure 2A ou de la Figure 2B;
La Figure 4 représente un mode de réalisation d'un dispositif de modification structurelle permettant notamment d'appliquer le procédé avec contrôle de modification structurelle locale, dont les principales étapes sont schématisées sur la Figure 3; et
La Figure 5 représente l'interaction d'un ion positif multichargé avec la surface de la plaquette de la Figure 1, lors de l'application du procédé selon l'invention.

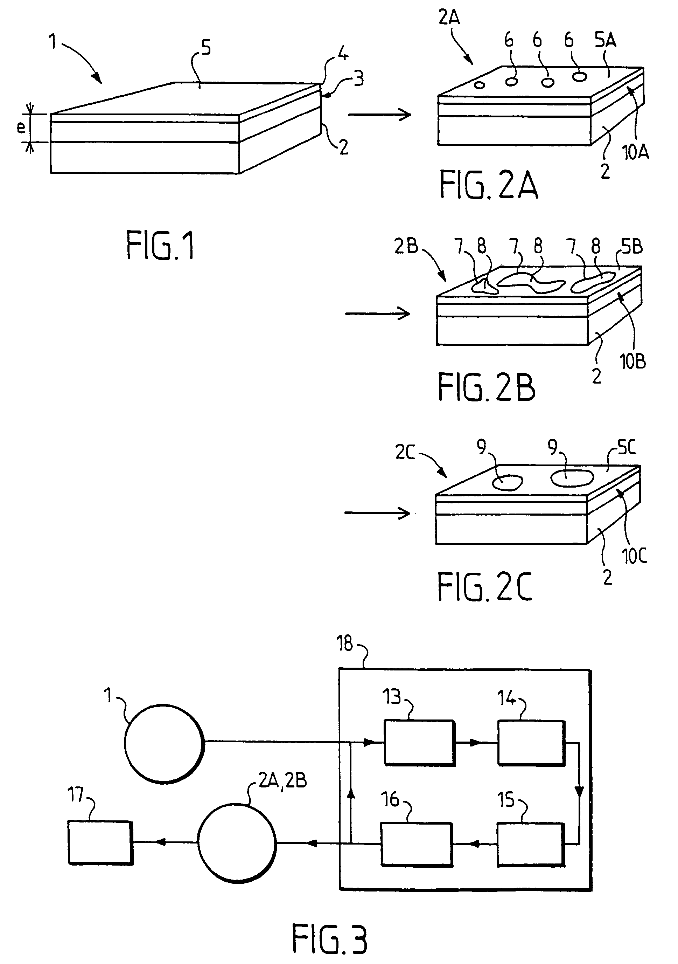

Une plaquette 1 (Figure 1) comprend un substrat 2 de silicium recouvert d'une couche 3 de diamant déposé sur le substrat 2. La couche 3, ayant une épaisseur e par exemple comprise entre 1 et 500 µm, est passivée par une monocouche 4 d'hydrogène ou d'oxygène. La couche 3 définit ainsi une surface 5, qui représente la partie superficielle de la plaquette 1 occupée par la couche de diamant 3. Le diamant étant un très bon isolant électrique, la couche 3 est très isolante sous la monocouche 4.

Le procédé de traitement décrit ci-après permet de transformer la plaquette 1 de trois manières possibles:
- en une plaquette 2A dans laquelle la surface 5A comprend une couche de diamant 10A pourvue d'îlots conducteurs 6 de très petites dimensions, inférieures à 150 nm, avantageusement inférieures à 10 nm et préférentiellement comprises entre 2 et 6 nm (Figure 2A);
- en une plaquette 2B ayant une surface 5B comprenant une couche de diamant 10B dans laquelle sont tracés des traits conducteurs 7 délimitant des motifs isolants 8 (Figure 2B): ou
- en une plaquette 2C ayant une surface 5C comprenant une couche de diamant 10C dans laquelle sont formées des fractions de surface 9 conductrices (Figure 2C).

Les deux premières réalisations (plaquettes 2A et 2B) correspondent à un traitement sélectif local de surface, la troisième réalisation (plaquette 2C) pouvant également être obtenue par une modification structurelle locale. Un cas particulier de la troisième réalisation est celui où la surface est entièrement traitée. Une des particularités extrêmement intéressante des plaquettes 2A et 2B et 2C (en dehors du traitement de toute la surface 5) est que des zones très conductrices, dont les dimensions peuvent être parfaitement maîtrisées, avoisinent des zones très isolantes. Plus précisément, les îlots conducteurs 6 ou les traits conducteurs 7, de même que les fractions de surface 9, ont des propriétés électriques similaires à celles du graphite. Selon les procédés de traitement conduisant aux plaquettes 2A, 2B et éventuellement 2C, une première forme de modification structurelle locale, aléatoire, présente l'avantage de la rapidité et une seconde forme de modification structurelle locale, contrôlée spatialement, présente l'avantage de la précision.

L'obtention de plaquettes du type 2A est particulièrement intéressante dans le domaine de la microélectronique, car les îlots conducteurs 6 dont le diamètre peut être suffisamment maîtrisé, peuvent servir de réservoirs à un électron. Des informations peuvent ainsi être stockées dans la plaquette 1 selon la présence ou non d'un électron dans chacun de ces réservoirs.

Les plaquettes du type 2A sont également utiles pour la fabrication des cathodes froides. Dans ce cas, les îlots conducteurs 6 servent de réservoirs de réalimentation de telles cathodes froides.

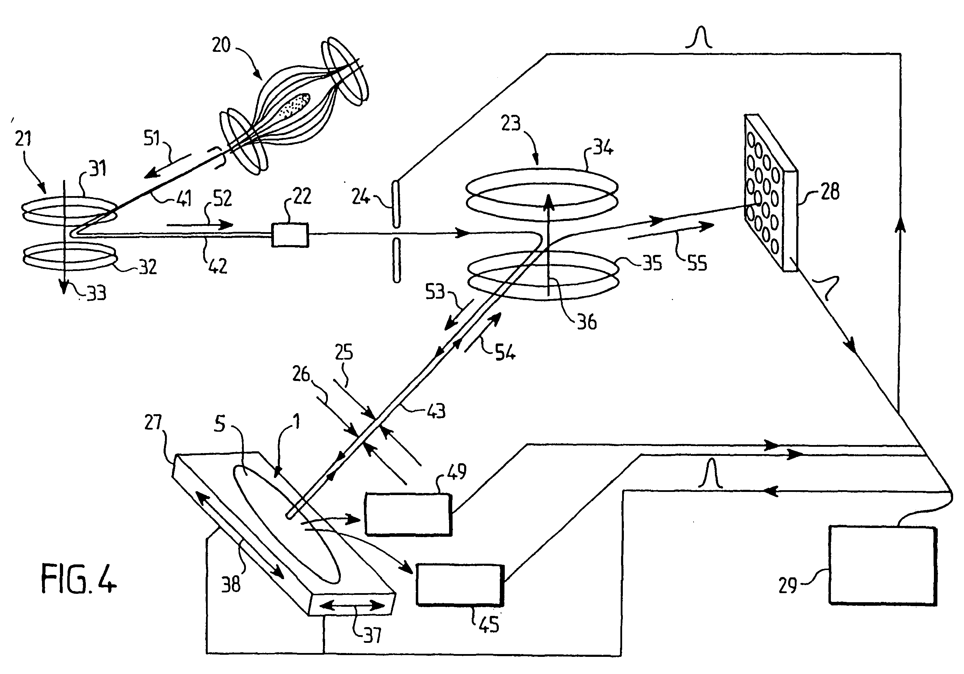

Le procédé de traitement de la surface 5 va maintenant être détaillé dans un mode de mise en oeuvre particulier, reposant sur l'utilisation d'un dispositif de modification structurelle locale spécifique représenté sur la Figure 4. Ce dispositif permet l'obtention de l'une quelconque des plaquettes 2A, 2B ou 2C, autorise un traitement aléatoire ou contrôlé spatialement, et rend possible une interaction entre un faisceau d'ions et la surface 5 avec ou sans contact.

Le dispositif de modification structurelle locale comprend une source d'ions 20 produisant des ions positifs multichargés. La source d'ions 20 peut utiliser une préparation des ions à l'intérieur d'un plasma très chaud confiné dans des structures magnétiques, telles qu'une source ECR (Electron Cyclotron Resonance). Elle peut aussi avoir pour principe de fonctionnement la compression de faisceaux d'électron dans un solénoïde, des atomes injectés dans le faisceau d'électron étant simultanément ionisés et piégés par charge d'espace. La source d'ions 20 peut ainsi être du type EBIS (Electron Beam Ion Source).

Les ions émis par la source d'ions 20 peuvent être par exemple de l'argon, chargé Ar¹⁷⁺ ou Ar¹⁸⁺, de l'oxygène ou de l'uranium. Ils peuvent aussi consister en des ions plus légers tels que du bore ou du carbone. Le nombre de charges positives peut varier de quelques unités à 92 pour l'uranium.

La source d'ions 20 produit ainsi un faisceau 41 des ions selon une première direction 51. Les ions émis ont une énergie cinétique initiale de l'ordre de plusieurs keV/q, par exemple comprise entre 5 et 20 keV/q, q désignant le nombre de charges positives de chacun de ces ions.

Le faisceau 41 est dirigé vers des moyens de sélection d'une espèce ionique choisie, par exemple Ar¹⁷⁺. Les moyens de sélection consistent avantageusement en des premiers moyens d'application 21 d'un champ magnétique 33, qui comprend deux bobines 31 et 32 en vis-à-vis ou aimants permanents. Le champ magnétique 33 est avantageusement uniforme. Il peut aussi être non uniforme de façon à être focalisant. Le champ magnétique 33 est avantageusement perpendiculaire à la direction 51 du faisceau 41 incident. Les moyens de sélection produisent ainsi un faisceau 42 des ions sélectionnés dans une direction 52. En gravure contrôlée, les ions du faisceau 42 sont préférentiellement envoyés les uns après les autres. En gravure aléatoire, ils sont envoyés en des endroits différents, chacun des ions étant capable de produire une empreinte sur la surface 5 pour la formation d'un îlot conducteur 6.

Dans une variante de réalisation, les moyens de sélection sont des moyens d'application d'un champ électrique.

Le dispositif de modification structurelle locale comprend préférentiellement un système de contrôle direct de position du faisceau 42, référencé 22.

Le dispositif de modification structurelle locale comprend ensuite des moyens d'interruption du faisceau 42, comportant avantageusement un obturateur 24 de faisceau à commande électronique. Cet obturateur 24 est destiné à interrompre le faisceau 42 lorsqu'une modification structurelle locale est détectée sur la surface 5.

Dans une variante de réalisation, l'obturateur 24 est remplacé par des moyens d'application d'un champ électrique perpendiculaire à la direction 52 du faisceau 42, l'application et la suppression de ce champ électrique jouant respectivement le rôle de la fermeture et l'ouverture de l'obturateur 24.

Le faisceau 42 est dirigé vers des moyens de guidage, guidant le faisceau 42 vers la surface 5 à traiter. Ces moyens de guidage consistent avantageusement en des seconds moyens d'application 23 d'un champ magnétique uniforme 36, comprenant deux bobines 34 et 35 en vis-à-vis ou aimants permanents. Le champ magnétique 36 étant de préférence perpendiculaire à la direction 52 de propagation du faisceau 42, dirige ainsi le faisceau 42 dans une direction 53 vers la surface 5, préférentiellement en incidence normale.

Dans une variante de réalisation, les moyens de guidage consistent en des moyens d'application d'un champ électrique, statique ou pulsé.

Préférentiellement, des moyens d'interruption du faisceau sont également présents en aval des bobines 34 et 35.

Le dispositif de modification structurelle locale comprend aussi, avantageusement, un système de localisation spatiale du faisceau 42, consistant par exemple en un ou plusieurs collimateurs 25, 26. Pour un traitement de haute précision, les collimateurs sont nanométriques.

La plaquette 1 faisant office de cible est montée sur un translateur 27, qui permet des mouvements selon deux directions 37 et 38 orthogonales entre elles, et perpendiculaires à la direction 53 du faisceau 42. Le translateur 27 comprend par exemple deux quartz piézo-électriques ou deux céramiques.

Dans la mise en oeuvre avec interaction sans contact, un champ électrique de décélération des ions du faisceau 42 est appliqué au voisinage de la cible, par polarisation de celle-ci. Ce champ électrique décélère suffisamment les ions du faisceau 42 pour que ceux-ci extraient des électrons de la surface 5 sans contact avec cette surface et soient rétroréfléchis sous forme d'atomes creux.

Ce champ électrique de décélération donne aux ions une énergie qui peut être aussi basse que 0,025 eV/q, de manière contrôlée. L'application du champ électrique peut être effectuée au moyen d'un condensateur plan avec potentiomètre.

Dans une variante de réalisation, la décélération n'est pas effectuée sur la cible mais à un endroit quelconque de la ligne de faisceau, par polarisation de la ligne.

Les atomes creux rétroréfléchis par la surface 5 forment un faisceau 43, qui part dans une direction 54 parallèle à la direction 53 et en sens opposé au faisceau 42. Le faisceau 43 d'atomes creux traverse ainsi les collimateurs 25 et 26, l'obturateur 24 et les moyens d'application 23 du champ magnétique 36, dans l'exemple illustré. Ce champ magnétique 36 dévie le faisceau 43 dans une direction 55, vers une surface de détection 28.

La surface de détection 28 donne la position, et avantageusement la vitesse et la charge, des atomes creux du faisceau 43 incident. Cette surface de détection 28 peut être par exemple un réseau de chaneltrons.

Le dispositif de modification structurelle locale comporte aussi un appareil de mesure 49 de photons, notamment de rayons X, émis lors de passages d'électrons d'une couche électronique à une autre des atomes creux du faisceau 43 et/ou d'atomes creux formés dans la surface 5.

Avantageusement, le dispositif de modification structurelle locale comporte aussi un système de détection 45 détectant des électrons émis par effet Auger par les atomes creux, des noyaux d'hydrogène décapés ou des atomes de la cible expulsés de la surface 5, une gerbe d'électrons émis, des photons émis par des atomes de la surface de gravure et/ou une charge électrique apparaissant sur la cible.

Dans un mode de réalisation avec contact, mais sans pénétration de la surface 5, les moyens de décélération sont également présents et activés dans le dispositif de gravure. Dans un autre mode de réalisation avec contact et pénétration, les moyens de décélération sont supprimés ou désactivés, ou laissent au faisceau d'ions 42 une énergie suffisante pour pénétrer dans la surface 5.

Les faisceaux 41, 42 et éventuellement 43 et la surface 5 de la plaquette 1 sont préservés de l'air ambiant par une enceinte de mise sous vide. Le dispositif de modification structurelle locale comprend aussi une unité de traitement 29 raccordé à l'obturateur 24, au translateur 27, à la surface de détection 28, au système de détection 45 et à l'appareil de mesure 49. Cette unité de traitement 29 reçoit des signaux en provenance de la surface de détection 28, du système de détection 45 et de l'appareil de mesure 49, et est à même de commander l'ouverture et la fermeture de l'obturateur 24 ainsi que des déplacements du translateur 27.

Le dispositif de modification structurelle locale est préférentiellement complété par un microscope à effet tunnel et/ou par un microscope à force atomique, effectuant des contrôles locaux de conductivité topographique et/ou électrique de la surface 5 traitée.

Bien entendu, il est possible de ne conserver que certains des moyens de détection, selon les applications visées et la nature et la précision des résultats souhaités.

En fonctionnement pour une interaction sans pénétration de la surface 5, lors d'une étape de modification structurelle locale 18 (Figure 3), on effectue successivement les opérations qui suivent. On produit le faisceau 41 d'ions positifs multichargés au moyen de la source d'ions 20, on sélectionne une espèce ionique de ce faisceau 41 par les moyens d'application 21 du champ magnétique 33, on guide le faisceau 42 obtenu vers la surface 5 par les moyens d'application 23 du champ magnétique 36 en effectuant un contrôle direct de position par le système 22 et une localisation spatiale par les collimateurs 25 et 26 et on décélère le faisceau 42.

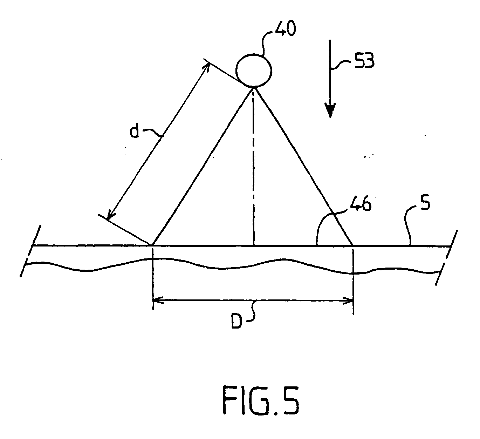

Lorsque les ions du faisceau 42 sont suffisamment proches de la surface 5, ils commencent à interagir avec celle-ci. Les ions peuvent capturer les électrons de la plaquette 1 dès qu'ils parviennent dans une zone de capture s'étendant jusqu'à une distance d au-dessus de la surface 5. Ainsi, dès qu'un ion 40 pénètre dans la zone de capture, il interagit avec une portion 46 de cette surface 5 définissant approximativement un disque de diamètre D ayant des contours à une distance d de l'ion 40, comme représenté sur la Figure 5.
L'ion 40 attire et extrait des électrons superficiels de la portion 46 tout au long de son approche dans la zone de capture. On commande cette approche en ajustant l'énergie cinétique de l'ion 40 grâce au champ électrique de décélération. L'ion 40 capture des électrons qui le transforment en atome creux. Cet atome creux est ensuite rétrodiffusé sans contact par effet trampoline lorsque les conditions expérimentales l'autorisent et on le dirige vers la surface de détection 28.

L'extraction d'électrons de la surface 5 provoque une rupture locale de la structure cristalline du diamant, responsable de sa très grande résistivité. Ce phénomène physique entraîne un changement local de propriétés électriques, qui conduit à la formation d'une zone conductrice au sein de la couche 3 de diamant très isolante.

La modification structurelle locale repose sur la succession et la répétition de quatre opérations 13-16 (Figure 3), commandés par l'unité de traitement 29.

Dans une première opération 13, on détecte l'arrivée sur la surface de détection 28 des particules issues de la surface 5, l'émission, au voisinage de la surface de photons, préférentiellement d'un spectre de rayon X ou d'électrons, au moyen de l'appareil de mesure 49 et/ou un ou plusieurs signaux produits par le système de détection 45. L'unité de traitement 29 reçoit ainsi un ou plusieurs signaux correspondant à ces détections. Dans une deuxième opération 14, on interrompt alors l'arrivée du faisceau 42 sur la cible, en commandant la fermeture de l'obturateur 24. Dans une troisième opération 15, on déclenche ensuite la mise en mouvement contrôlée du translateur 27, sur une distance avantageusement de l'ordre du nanomètre. Dans une quatrième opération 16, on commande l'ouverture de l'obturateur 24, de telle sorte que le faisceau 42 peut de nouveau parvenir sur la surface 5.

Par la répétition des opérations 13 à 16, on produit une modification structurelle locale dans les zones correspondant aux parties conductrices prédéterminées. On peut ainsi obtenir la plaquette 1A avec îlots conducteurs 6 ou la plaquette 1 B avec traits conducteurs 7, par une succession d'interactions locales à des endroits biens définis.

Préférentiellement, on effectue lors d'une étape ultérieure 17 un contrôle local de conductivité électrique de la surface 5, au moyen des microscopes à effet tunnel et/ou à force atomique.

Pour mettre en oeuvre le procédé avec pénétration de la surface 5 par les ions du faisceau 42, on peut désactiver les moyens de décélération. L'interaction entre chaque ion 40 et la surface 5 est alors dans un premier temps potentielle (interaction à distance), puis dans un second temps, cinétique (pénétration de la surface 5). Les informations utilisées proviennent du système de détection 45 et de l'appareil de mesure 49, ainsi qu'éventuellement de la surface de détection 28, des atomes ou des ions étant récupérés après expulsion de la surface 5.

Le dispositif de modification structurelle locale détaillé ci-dessus peut également être utilisé pour un traitement aléatoire, l'unité de traitement 29 commandant alors simplement des mouvements du translateur 27 sans tenir compte des résultats de détection. L'obturateur 24 est dans ce cas désactivé. Une telle mise en oeuvre est avantageuse pour des raisons de rapidité, même si elle ne permet pas de maîtriser l'emplacement des zones conductrices sur la surface 5. Préférentiellement, les ions du faisceau 42 sont alors envoyés en même temps en des endroits différents sur la surface 5 (plutôt que les uns après les autres).

De plus, le dispositif de modification structurelle locale peut permettre de traiter des fractions 9 de la surface 5, de manière à obtenir une plaquette du type 2C.

## Revendications

1. Procédé de traitement d'une surface isolante (5) ayant une structure de diamant, dans lequel :
• on produit des ions (40) ayant chacun au moins trois charges positives, et
• on envoie un faisceau (42) desdits ions positifs multichargés vers la surface de diamant (5), de façon à provoquer sur au moins une zone (6, 7, 9) de cette surface (5), une modification structurelle locale permettant de rendre conductrice ladite zone (6, 7, 9),
• chaque ion (40) ayant une charge, une énergie cinétique et, une incidence telles que la modification structurelle produite s'étende sur une superficie supérieure à quatre fois et préférentiellement à dix fois la surface d'un atome dudit diamant et inférieure à 22500 nm².

2. Procédé de traitement selon la revendication 1, **caractérisé en ce qu'**on envoie ledit faisceau (42) de façon à former au moins un îlot conducteur (6) ayant un diamètre inférieur à 150 nm.

3. Procédé de traitement selon la revendication 2, **caractérisé en ce que** lesdits îlots conducteurs (6) ont un diamètre inférieur à 10 nm et préférentiellement compris entre 2 et 6 nm.

4. Procédé de traitement selon la revendication 3, **caractérisé en ce qu'**on utilise lesdits îlots (6) comme réservoirs à un électron.

5. Procédé de traitement selon la revendication 2, **caractérisé en ce qu'**on utilise lesdits îlots conducteurs (6) comme réservoirs de réalimentation de cathodes froides.

6. Procédé de traitement selon la revendication 1, **caractérisé en ce qu'**on envoie ledit faisceau de façon à former des traits conducteurs (7) délimitant des motifs isolants (8).

7. Procédé de traitement selon la revendication 1, **caractérisé en ce qu'**on envoie ledit faisceau (42) de façon à rendre conductrice au moins une fraction (9) de la surface (5) du diamant.

8. Procédé de traitement selon l'une quelconque des revendications 2 à 5, **caractérisé en ce que** les ilots conducteurs (6) sont répartis de manière aléatoire sur la surface (5).

9. Procédé de traitement selon l'une quelconque des revendications 1 à 8, **caractérisé en ce qu'**on envoie le faisceau (42) d'ions de façon qu'il entre en contact avec la surface (5) et la pénètre.

10. Procédé de traitement selon la revendication 9, **caractérisé en ce qu'**on produit lesdits ions ayant une énergie cinétique initiale comprise entre 5 eV/q et 500 keV/q.

11. Procédé de traitement selon l'une quelconque des revendications 1 à 8, **caractérisé en ce qu'**on applique au faisceau (42) une tension de décélération à proximité de la surface (5), de manière à donner aux ions (40) du faisceau (42) une vitesse moyenne commandée, lesdits ions (40) extrayant des électrons des atomes de diamant sans entrer en contact avec la surface (5) et modifiant ainsi les liaisons entre lesdits atomes.

12. Procédé de traitement selon la revendication 11, **caractérisé en ce qu'**on ralentit lesdits ions de façon à ce qu'ils aient à proximité de la surface (5) une énergie cinétique comprise entre 5.10⁻² eV/q et 5 eV/q.

13. Procédé de traitement selon l'une quelconque des revendications précédentes, **caractérisé en ce que** la surface (5) de diamant est une surface de diamant monocristallin.

14. Procédé de traitement selon l'une quelconque des revendications 1 à 12, **caractérisé en ce que** la surface (5) de diamant est une surface de diamant polycristallin, préférentiellement obtenue par une technique de dépôt de vapeur chimique (CVD) ou une technique hautes pressions hautes températures (HPHT).

15. Procédé de traitement selon la revendication 14, **caractérisé en ce que** la surface (5) de diamant est une couche (3) déposée sur un substrat (2).

16. Procédé de traitement selon l'une quelconque des revendications 1 à 12, **caractérisé en ce que** la surface (5) de diamant est une surface de carbone sp 3 amorphe.

17. Procédé de traitement selon l'une quelconque des revendications précédentes, **caractérisé en ce que** la surface (5) de diamant est passivée par une monocouche atomique (4), préférentiellement d'hydrogène ou d'oxygène.

18. Surface (5) de diamant traitée par le procédé selon l'une des revendications 1 à 17, **caractérisée par le fait qu'**elle comprend des îlots conducteurs (6) ayant un diamètre supérieur à 2 et préférentiellement à 3 distances atomiques et inférieur à 10 nm.

19. Surface de diamant selon la revendication 18, **caractérisée en ce que** lesdits îlots (6) ont un diamètre compris entre 2 et 6 nm.

20. Surface de diamant selon l'une des revendications 18 ou 19, **caractérisée en ce que** lesdits îlots (6) ont des propriétés conductrices similaires à celles du graphite.

21. Application de la surface (5) selon l'une quelconque des revendications 18 à 20 à la microélectronique, dans laquelle on utilise lesdits îlots conducteurs (6) comme réservoirs à un électron.

22. Application du procédé selon l'une quelconque des revendications 1 à 17 à la fabrication de cathodes froides, notamment pour écrans plats.

## Claims

1. A treatment method of an insulating surface (5) having a diamond structure, wherein:
• ions (40) are produced, each having at least three positive charges, and
• a beam (42) of said positive multicharged ions is sent towards the diamond surface (5), in order to make on at least one zone (6, 7, 9) of said surface (5), a local structural modification enabling to make conductive said zone (6, 7, 9),
• each ion (40) having a charge, a kinetic energy and an incidence such that the obtained structural modification extends on a surface area greater than four preferably greater than ten atomic surfaces of said diamond and smaller than 22,500 nm².

2. A treatment method according to claim 1, **characterised in that** said beam (42) is sent in order to form at least one conductive islet (6) with a diameter smaller than 150 nm.

3. A treatment method according to claim 2, **characterised in that** said conductive islets (6) have a diameter smaller than 10 nm and preferably ranging between 2 and 6 nm.

4. A treatment method according to claim 3, **characterised in that** said islets (6) are used as one electron reservoirs.

5. A treatment method according to claim 2, **characterised in that** said conductive islets (6) are used as reservoirs for replenishing cold cathodes.

6. A treatment method according to claim 1, **characterised in that** the beam is sent in order to form conductive lines (7) delineating insulating patterns (8).

7. A treatment method according to claim 1, **characterised in that** said beam (42) is sent in order to make at least one portion (9) of the diamond surface (5) conductive.

8. A treatment method according to any one of claims 2 to 5, **characterised in that** the conductive islets (6) are randomly distributed on the surface (5).

9. A treatment method according to any one of claims 1 to 8, **characterised in that** the ion beam (42) is sent so that it contacts the surface (5) and penetrates said surface.

10. A treatment method according to claim 9, **characterised in that** said ions with an initial kinetic energy ranging between 5 eV/q and 500 keV/q are generated.

11. A treatment method according to any one of claims 1 to 8, **characterised in that** it is provided to the beam (42) a deceleration voltage close to the surface (5) in order to provide to the ions (40) of the beam (42) a controlled average speed, whereas said ions (40) extract electrons from the diamond atoms without contacting the surface (5) and therefore modify the bonds between said atoms.

12. A treatment method according to claim 11, **characterised in that** said ions are slowed down so that they have close to the surface (5) a kinetic energy ranging between 5,10⁻² eV/q and 5 eV/q.

13. A treatment method according to any one of the previous claims, **characterised in that** the diamond surface (5) is a monocrystalline diamond surface.

14. A treatment method according to any one of claims 1 to 12, **characterised in that** the diamond surface (5) is a polycrystalline diamond surface, preferably obtained by a CVD technique (Chemical Vapour Deposition) or a HPHT technique (High Pressure High Temperature).

15. A treatment method according to claim 14, **characterised in that** the diamond surface (5) is a layer (3) deposited on a substrate (2).

16. A treatment method according to any one of claims 1 to 12, **characterised in that** the diamond surface (5) is an amorphous carbon sp3 surface.

17. A treatment method according to any one of the previous claims, **characterised in that** the diamond surface (5) is passivated by an atomic monolayer (4), preferably made of hydrogen or oxygen.

18. A diamond surface (5) treated by the method according to one of claims 1 to 17, **characterised in that** it comprises conductive islets (6) with a diameter greater than 2 and preferably to 3 atomic distances and lower than 10 nm.

19. A diamond surface according to claim 18, **characterised in that** said islets (6) have a diameter ranging between 2 and 6 nm.

20. A diamond surface according to any one of claim 18 or 19, **characterised in that** said islets (6) have conductive properties similar to those of graphite.

21. Application of the surface (5) according to any one of claims 18 to 20 to micro-electronics, wherein one uses said conductive islets (6) as one electron reservoirs.

22. Application of the method according to any one of claims 1 to 17 to the production of cold cathodes, particularly for flat screens.

## Patentansprüche

1. Verfahren zur Behandlung einer isolierenden Oberfläche (5) mit Diamantstruktur, wobei:
• man Ionen (40) erzeugt, die jeweils mindestens drei positive Ladungen aufweisen, und
• man ein Bündel (42) der mehrfach positiv geladenen Ionen so in Richtung der Diamantoberfläche (5) sendet, dass auf mindestens einer Zone (6, 7, 9) dieser Oberfläche (5) eine lokale Strukturmodifikation verursacht wird, die ein Leitfähigmachen der Zone (6, 7, 9) ermöglicht,
• jedes Ion (40) eine solche Ladung, eine solche kinetische Energie und einen solchen Auftreffwinkel hat, dass die erzeugte Strukturmodifikation sich über eine Fläche erstreckt, die größer als das Vierfache und vorzugsweise das Zehnfache der Oberfläche eines Atoms des Diamanten und kleiner als 22 500 nm² ist.

2. Behandlungsverfahren nach Anspruch 1, **dadurch gekennzeichnet, dass** man das Bündel (42) so sendet, dass mindestens eine kleine leitende Insel (6) mit einem Durchmesser von weniger als 150 nm gebildet wird.

3. Behandlungsverfahren nach Anspruch 2, **dadurch gekennzeichnet, dass** die leitenden kleinen Inseln (6) einen Durchmesser von weniger als 10 nm und vorzugsweise zwischen 2 und 6 nm haben.

4. Behandlungsverfahren nach Anspruch 3, **dadurch gekennzeichnet, dass** man die kleinen Inseln (6) als Speicher für ein Elektron verwendet.

5. Behandlungsverfahren nach Anspruch 2, **dadurch gekennzeichnet, dass** man die leitenden kleinen Inseln (6) als Speicher zur Nachspeisung von Kaltkathoden verwendet.

6. Behandlungsverfahren nach Anspruch 1, **dadurch gekennzeichnet, dass** man das Bündel so sendet, dass leitende Linien (7) gebildet werden, die isolierende Muster (8) abgrenzen.

7. Behandlungsverfahren nach Anspruch 1, **dadurch gekennzeichnet, dass** man das Bündel (42) so sendet, dass mindestens ein Teil (9) der Oberfläche (5) des Diamanten leitend wird.

8. Behandlungsverfahren nach einem der Ansprüche 2 bis 5, **dadurch gekennzeichnet, dass** die leitenden kleinen Inseln (6) zufällig über die Oberfläche (5) verteilt sind.

9. Behandlungsverfahren nach einem der Ansprüche 1 bis 8, **dadurch gekennzeichnet, dass** man das Ionenbündel (42) so leitet, dass es in Kontakt mit der Oberfläche (5) tritt und in sie eindringt.

10. Behandlungsverfahren nach Anspruch 9, **dadurch gekennzeichnet, dass** man die Ionen mit einer kinetischen Anfangsenergie zwischen 5 eV/q bis 500 keV/q erzeugt.

11. Behandlungsverfahren nach einem der Ansprüche 1 bis 8, **dadurch gekennzeichnet, dass** man in der Nähe der Oberfläche (5) eine Verzögerungsspannung so auf das Bündel (42) einwirken lässt, dass den Ionen (40) des Bündels (42) eine mittlere gesteuerte Geschwindigkeit verliehen wird, wobei die Ionen (40) Elektronen von Diamantatomen herauslösen, ohne in Kontakt mit der Oberfläche (5) zu gelangen und folglich die Bindungen zwischen den Atomen zu modifizieren.

12. Behandlungsverfahren nach Anspruch 11, **dadurch gekennzeichnet, dass** man die Ionen so abbremst, dass sie in der Nähe der Oberfläche (5) eine kinetische Energie zwischen 5·10⁻² eV/q und 5 eV/q haben.

13. Behandlungsverfahren nach einem der vorhergehenden Ansprüche, **dadurch gekennzeichnet, dass** die Diamantoberfläche (5) eine Oberfläche von monokristallinem Diamant ist.

14. Behandlungsverfahren nach einem der Ansprüche 1 bis 12, **dadurch gekennzeichnet, dass** die Diamantoberfläche (5) eine Oberfläche aus polykristallinem Diamant ist, die vorzugsweise durch eine Technik der Abscheidung aus der Gasphase (CVD) oder eine Hochdruck-Hochtemperatur-Technik (HPHT) erhalten wird.

15. Behandlungsverfahren nach Anspruch 14, **dadurch gekennzeichnet, dass** die Diamantoberfläche (5) eine auf einem Substrat (2) abgeschiedene Schicht (3) ist.

16. Behandlungsverfahren nach einem der Ansprüche 1 bis 12, **dadurch gekennzeichnet, dass** die Diamantoberfläche (5) eine Oberfläche aus amorphem sp³-Kohlenstoff ist.

17. Behandlungsverfahren nach einem der vorhergehenden Ansprüche, **dadurch gekennzeichnet, dass** die Diamantoberfläche (5) durch eine Mono-Atomschicht (4) vorzugsweise aus Wasserstoff oder Sauerstoff passiviert ist.

18. Diamantoberfläche (5), die mit dem Verfahren nach einem der Ansprüche 1 bis 17 behandelt ist, **dadurch gekennzeichnet, dass** sie leitende kleine Inseln (6) mit einem Durchmesser von mehr als 2 und vorzugsweise 3 Atomabständen und weniger als 10 nm umfasst.

19. Diamantoberfläche nach Anspruch 18, **dadurch gekennzeichnet, dass** die kleinen Inseln (6) einen Durchmesser zwischen 2 und 6 nm haben.

20. Diamantoberfläche nach einem der Ansprüche 18 oder 19, **dadurch gekennzeichnet, dass** die kleinen Inseln (6) Leitfähigkeitseigenschaften haben, die denjenigen von Graphit ähnlich sind.

21. Anwendung der Oberfläche (5) nach einem der Ansprüche 18 bis 20 in der Mikroelektronik, wobei man die leitenden kleinen Inseln (6) als Speicher für ein Elektron verwendet.

22. Anwendung des Verfahrens nach einem der Ansprüche 1 bis 17 bei der Herstellung von Kaltkathoden insbesondere für Flachbildschirme.
